(19)

Europäisches
Patentamt
European
Patent Office
Office européen
des brevets

(11) **EP 2 113 973 A1**

(12) **EUROPEAN PATENT APPLICATION**

(43) Date of publication:
**04.11.2009 Bulletin 2009/45**

(51) Int Cl.:
*H01S 5/0625* (2006.01)   *H01S 5/065* (2006.01)
*H01S 5/12* (2006.01)   *H01S 1/02* (2006.01)
*H01S 5/042* (2006.01)   *H01S 5/06* (2006.01)
*H01S 5/40* (2006.01)

(21) Application number: **08305135.9**

(22) Date of filing: **29.04.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(71) Applicant: **Alcatel Lucent
75008 Paris (FR)**

(72) Inventors:
• **Duan, Guang-Hua
92330 Sceaux (FR)**

• **Van Dijk, Frederic
91460 Marcoussis (FR)**
• **Shen, Alexandre
91220 Bretigny sur Orge (FR)**
• **Accard, Alain
91460 Marcoussis (FR)**

(74) Representative: **Shamsaei Far, Hassan
Alcatel Lucent
Intellectual Property & Standards
54 rue La Boétie
75008 Paris (FR)**

(54) **Laser source and method for generating millimeter wave**

(57)    The present invention refers to a laser source comprising laser sections wherein at least three laser sections comprise each

- a distributed feedback laser (1) with a Bragg grating (5) having a predetermined grating period,
- an active layer (3) and
- an electrode adapted for being injected by an injection current (I)

wherein the grating periods of said at least three laser sections are different from each other and

wherein respective injection current values of said at least three laser sections are adjusted thereby adjusting the shape and chirp of a pulse generated by said at least three laser sections.

Laser operation is adjusted such that the difference between any two neighbouring laser frequencies (F1,F2,F3) becomes equal. The laser may be actively or passively mode-locked. Millimeter waves may be generated by four-wave mixing.

Fig.1

**Description**

**BACKGROUND OF THE INVENTION**

The present invention relates to the field of laser sources and more particularly of mode-locked laser sources.
Laser sources allow to produce optical signals with narrow spectral bandwidth thanks to the mode selection achieved by their cavity.
Mode-locking is a technique used to produce pulses of light of extremely short duration. The basis of the technique is to induce a fixed phase relationship between the modes of the laser's resonant cavity. The laser is then said to be phase-locked or mode-locked.
Thus, pulses of light of short duration with narrow spectral bandwidth can be produced. Moreover, a dual-mode configuration can be used to create millimeter-wave signal due to the four-wave-mixing effect.
Nevertheless, with the existing mode-locked laser sources of the state of the art, the shape and chirp of said generated pulses of light can hardly be adjusted and the millimeter-wave signals created by the dual-mode configuration comprise an undesirable phase noise.

**SUMMARY OF THE INVENTION**

One object of the present invention is to provide a new design and method to allow adjustment of the shape and chirp of short duration light pulses.
This adjustment is achieved by a laser source comprising laser sections wherein at least three laser sections comprise each

- a distributed feedback laser with a Bragg grating having a predetermined grating period,
- an active layer and,
- an electrode adapted for being injected by an injection current,

wherein the grating periods of said at least three laser sections are different from each other and
wherein respective injection current values of said at least three laser sections are adjusted thereby adjusting the shape and chirp of a pulse generated by said at least three laser sections.
Preferably, said at least three laser sections are shifted in frequency by a predetermined value with respect to each other, said at least three laser sections are shifted in phase by a predetermined value with respect to each other thereby achieving a control of a simultaneous emission frequency of said at least three sections.
Preferably, the predetermined value of the frequency shift between two of said at least three laser sections is in a range from 20 to 100 GHz.
Preferably, two laser sections of the at least three laser sections are injected with high intensity currents to produce a four-wave-mixing phenomenon whereas the other sections are injected with lower currents, the values of said lower currents being adjusted in order to control the shape of the generated pulses.
Preferably, the injection current value of a laser section is above a lasing threshold value.
Furthermore, the active layer of the distributed feedback laser is a quantum dot structure or a quantum well structure or a bulk structure.
Preferably, said at least three laser sections comprise an adjustable heating device allowing to adjust the instant phase shift of the emitted light.
Preferably, said adjustable heating device is a resistance.
Preferably, a plurality of laser sections comprise each a static phase shift adjustment device and at least one laser section does not comprise a static phase shift adjustment device.
In addition, the present invention offers a method for adjusting the pulse shape and chirp of a laser source, said laser source comprising laser sections wherein at least three laser sections have respective grating periods being different from each other, respective active layers and respective electrodes, the method comprising the steps of

- injecting an injection current by means of said electrode into a respective laser section,
- adjusting the respective injection current values of said laser sections thereby adjusting the shape and chirp of a pulse generated by said at least three laser sections.

Preferably, said at least three laser sections comprise a heating device and said method further comprising the step of

- adjusting the heating power produced by said heating device thereby adjusting the instant phase shift of said at least three laser sections in order to adjust the shape and chirp of a pulse generated by said at least three laser sections.

Preferably, static phase shifts between laser sections are adjusted in accordance with a geometrical organization of the laser source on a chip.

Alternatively, static phase shifts are adjusted by static phase shift adjustment devices located on the optical paths.

Alternatively, said method comprises the following steps of:

- setting value of said injection current above a lasing threshold,
- controlling instant phase shifts in order to make equal the frequency difference of the adjacent laser sections in the case when four-wave mixing is not occurring, and
- the step of adjusting static phase shifts by means of static phase shift adjustment devices located on the optical paths is performed in case where the implementation of the different laser sections does not set said static phase shifts.

Furthermore, the present invention offers a method for generating millimeter wave using a laser source comprising laser sections wherein at least three laser sections comprise a distributed feedback laser with a Bragg grating having respective grating periods wherein said respective grating periods are different from each other and comprise an active layer and an electrode, wherein an injection current is injected into the electrode, and wherein two laser sections of said at least three laser sections are injected with high intensity currents to produce a four-wave-mixing phenomenon, the other sections being injected by lower intensity currents in order to control the shape of the generated pulses.

**BRIEF DESCRIPTION OF THE DRAWINGS**

FIG.**1** is a diagram of sections of a mode-locked multisection distributed feedback (DFB) laser according to the present invention.

FIG.**2** is a plot of the optical spectrum in the case of a dual mode laser source, in the case when no nonlinear effect (namely four wave mixing) is occurring.

FIG.**3** is a plot of the optical spectrum from a dual mode laser source with secondary frequencies generated by the four-wave-mixing effect.

FIG.**4** is a plot of the optical spectrum from a four sections DFB laser source according to an embodiment of the invention.

FIG.**5** is a plot of the optical spectrum before settings and without mode locking provided by nonlinear effect such as four-wave mixing (FWM).

FIG.**6** is a plot of the optical spectrum after instant phase shift setting or after four-wave mixing (FWM) becomes efficient.

FIG.**7** is a plot of the optical spectrum after instant phase shift setting or after four-wave mixing (FWM) has become efficient and relative powers setting.

FIG.**8** is a plot of the optical spectrum after instant phase shift setting or after four-wave mixing (FWM) has become efficient and relative powers setting in the case of an odd number of modes.

**DETAILED DESCRIPTION OF EMBODIMENTS**

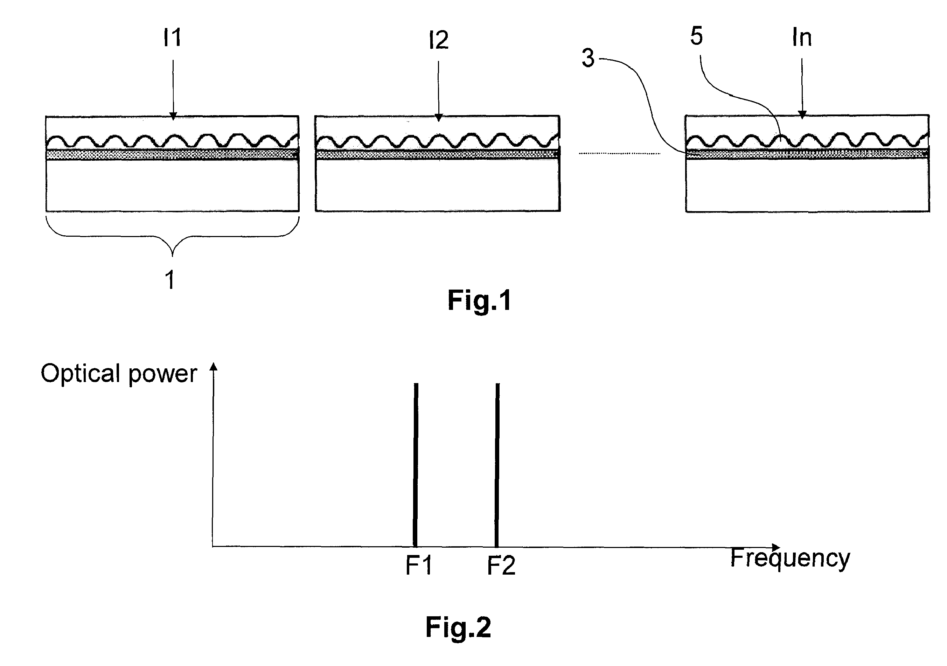

In a general aspect, the present invention relates to the use of a multi-section distributed feedback (DFB) laser where each section operates on a single longitudinal mode. Such a laser is represented in Fig.1. Each section comprises a DFB laser source 1 comprising an active layer 3 and a Bragg grating 5. In practice, any single-mode DFB laser configuration can be used for each section but a $\lambda/4$ phase-shifted DFB laser is preferred. The active layer 3 can be bulk, quantum well or preferably quantum dot structure to reduce time jitter. The frequency of the signal emitted by a section is determined by the Bragg grating period of said section. The grating periods of two adjacent sections are shifted with respect to each other such that the grating period of the $i^{th}$ section can be defined by

$$\Lambda_i = \Lambda_1 + (i-1)\,\delta$$

where A refers to a grating period and δ refers to the grating variation slope which could be positive or negative. In practice, the frequency difference between two adjacent sections can be adjusted for example between 20 and 100 GHz. In a preferred embodiment, each section is pumped electrically by an electrode but an alternative solution using optical pumping is possible. The value of the injection currents I of each section is set to be above a lasing threshold and are independently adjusted.

The output emission spectrum therefore consists of plurality of lines with nearly equal wavelength spacing between two neighbor lines.

Depending on the accuracy of the grating manufacturing, this wavelength spacing is not necessarily very precise. Thus, to ensure the initial control of the generated signals, the emission frequency of each section is accurately controlled. To achieve this control, a local heating device is designed for each section such that the thermal effect allows to control the phase shift and therefore the emission frequency. Said heating device can be, for example, a heating resistance. This implies the introduction of an additional electrode for each DFB section in order to adjust the current to produce the desired temperature and therefore the desired frequency change. This initial control can be set to initiate the mode locking described below.

In the case when nonlinear effect such as four wave mixing (FWM) is efficient enough to lock all the modes, no heating device is then needed to perform such control described in the previous paragraph.

Another element influencing the generated signal is the static phase shift induced by the difference of optical path (distance) between the different laser beams. This static phase shift can be controlled either by the geometrical organization of the different laser sources (integration of laser diodes on a single chip, integrated circuit or wafer) or static phase adjustment devices. These static phase adjustment devices are located on the optical paths of the different laser beams. If the whole system comprises N laser sources, N-1 static phase adjustment devices are needed to obtain a constant phase shift between the different light beams.

To generate signals of high intensity and short duration, mode-locking is used. Two types of mode-locking regimes can be used, either active or passive. In the active case, an external modulation is applied and the mode-locking is achieved through the locking of neighbor lines to the modulation side bands whereas in the passive case the mode-locking is achieved through internal nonlinear phenomenon such as four-wave-mixing.

Thus, by adjusting the values of the different injection currents of each section, harmonics can be created that allow to control the shape of the generated pulses.

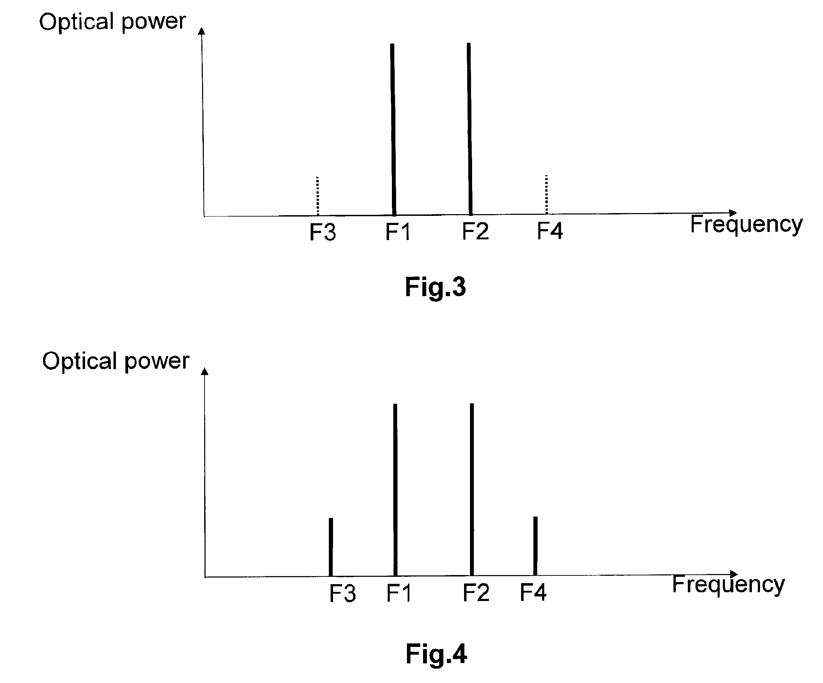

Besides, to produce millimeter waves, dual-mode configuration can be used. In this case, high intensity currents are applied on two different sections emitting at two different primary frequencies F1 and F2 as presented in Fig.2. The exact frequency of the millimeter wave produced is defined by the difference in frequency, deltaF, between F1 and F2 (deltaF=F2-F1). Besides, in the case of the four-wave-mixing, additional frequencies F3 and F4 are generated by the nonlinear interaction of the two primary frequencies. These frequencies correspond to F1-deltaF and F2+deltaF and are represented in Fig.3 where the continuous lines represent the injected signals and the dotted lines represent signals generated by four-wave-mixing. Interaction between said generated frequencies (F3 and F4) and the primaries (F1 and F2) gives rise to harmonics of the millimeter wave (2 deltaF, 3 deltaF...). As a consequence, these harmonics modify the shape of the generated millimeter wave. The problem is that the amplitude of these nonlinearly generated harmonics is not controlled which leads to the generation of a signal with undesired shape.

One embodiment of the present invention proposes the use of at least one additional section at frequency F3 or F4, said additional section being injected by a current with a lower intensity than the F1 and F2 sections injection currents. The optical spectrum of such embodiment is shown in Fig.4 where four active sections are used (at frequencies F1, F2, F3 and F4), allowing the control of the amplitude of the harmonics of the millimeter wave. Control of the amplitude of the different frequencies allows to control the phase of the generated pulses and thus reduces the generated phase noise. In practice, additional harmonics can be generated by interactions between F3 and F1 or F3 and F4 for example so that a higher number of sections could be used to control the shape of the generated pulses.

Furthermore, the present invention allows to control the chirp of the generated signal. To better understand this part of the present invention, theoretical explanations are provided.

The optical fields resulting from the different optical waves can be described as

$$E_k = E_{k0}\exp(j2\pi F_k t + \phi_k) \text{ with } k = 1, 2, \dots N. \qquad (Eq.1)$$

Where $E_{k0}$ is the amplitude of the $k^{th}$ optical wave, j is the imaginary constant, $F_k$ is the frequency of the $k^{th}$ optical wave, t is the time, $\phi_k$ is the phase of the $k^{th}$ optical wave and k is a constant.

In the case of a simultaneous propagation of optical waves, beating phenomena occur. In the case of N optical waves of optical frequencies $F_k$, the beating waves can be described by the following equation:

$$E=E_1+E_2+E_3+...+E_k+...+E_n=E_1\{1+\eta_2\exp(j\Omega t+\Delta\varphi_2+\delta\phi_2)+\eta_3\exp(2j\Omega t+\Delta\varphi_3+\delta\phi_3)+...$$
$$+\eta_k\exp((k-1)j\Omega t+\Delta\varphi_k+\delta\phi_k)+...+\eta_N\exp((N-1)j\Omega t+\Delta\varphi_N+\delta\phi_N)\} \qquad (Eq.2)$$

where $\Omega$ is the mean beating frequency ($\Omega=\text{mean}[2\pi(F_k-F_{k-1})]$ with $k=2, 3,...N$), $\eta$ is the amplitude ratio of the $k^{th}$ optical wave to the first optical wave ($\eta_k=E_{k0}/E_{10}$) and $\Delta\varphi_k$ is the static phase shift between the $k^{th}$ wave and the first wave ($\Delta\varphi_k=\phi_k-\phi_1$). The instant phase shift of the $k^{th}$ optical wave ($\delta\phi_k$) is introduced by a small difference between the beating frequency ($F_k-F_1$) and the average beating frequency ($(k-1)\Omega/(2\pi)$):

$$\delta\phi_k= 2\pi(F_k-F_1)t-(k-1)\Omega t.$$

In the ideal case where mode locking occurs (when FWM is efficient) and when phase fluctuations from individual modes are perfectly locked together, all the phase shift terms in equation 2 vanish and no chirp should be observed in the resulting optical signal. So, in this ideal case, k parameters ($E_{k0}$) can be used as independent parameters to tailor the pulse form of the output optical signal.

One of the other goals of the present invention is to control the beating signal given by Eq.2 thanks to physical adjustable parameters, in the case of non ideal mode locking. These parameters are the relative power amplitudes $\eta_k$ and the frequencies $F_k$ of the optical waves of each DFB section.

Eq.1 can be expressed by

$$E=E_1\alpha\exp(j\beta)=E_{10}\exp(j2\pi F_1t+\phi_1)\alpha\exp(j\beta) \qquad (Eq.3)$$

where $\alpha$ and $\beta$ are real numbers and represent respectively the amplitude modulation and the phase modulation of the beating wave.

The chirp can be defined by

$$\Delta F= 1/(2\pi)\ d\beta/dt \qquad (Eq.4)$$

It has to be noted that this $\Delta F$ is different from the deltaF described previously.

$\Delta F$ is the instantaneous frequency variation of the beating wave at the instant t.

It is therefore desired to find the conditions wherein the beating signal frequency remains the same over the time. Adjustment of the chirp comprises the following setting steps:

1) Setting of the instant phase shifts

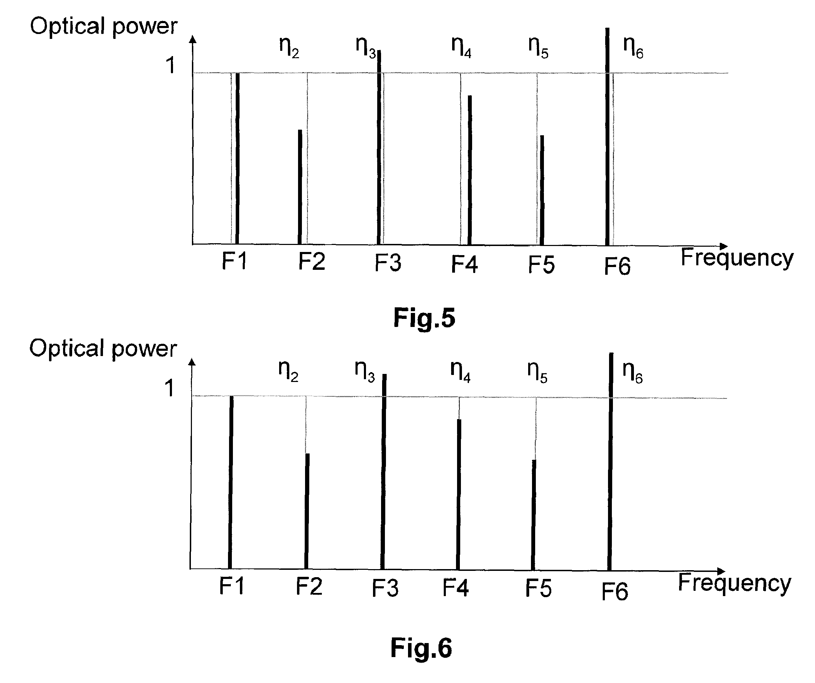

Fig.5 represents the optical spectrum without any settings in the case of 6 laser diodes. In this figure, we can observe that the relative amplitude of the spectral lines ($\eta$) as well as the spacing between said spectral lines are not constant.

To set as constant the frequency shift between the different optical waves coming from the different DFB lasers, one way is to use heating devices as described previously when FWM is not sufficient enough. As a consequence, we obtain

$$2\pi(F_k-F_{k-1})=\Omega \ \text{for } k=2...N \text{ and } \delta\phi_k=0.$$

Therefore, Eq.2 simplifies as follow

$$E=E_1+E_2+E_3+...+E_k+...+E_n=E_1\{1+\eta_2\exp(j\Omega t+\Delta\varphi_2)+\eta_3\exp(2j\Omega t+\Delta\varphi_3)+...$$

$$+\eta_k\exp((k-1)j\Omega t+\Delta\varphi_k)+...+\eta_N\exp((N-1)j\Omega t+\Delta\varphi_N)\} \qquad (Eq.5)$$

Fig.6 shows the influence of the adjustment of the instant phase shifts on the optical spectrum. As opposed to Fig.5, the frequency spacing between two adjacent rays is the same all over the spectrum which allows to control the instant phase shifts.

2) <u>Setting of the relative powers</u>

The second setting concerns the relative power of the spectral lines ($\eta_k$). This setting is achieved by the control of the injection current values as described previously. The need is to find the values allowing to eliminate (or at least substantially reduce) the chirp.

A first simple case comprises the following conditions:

- all the relative powers are set to 1 ($\eta_k=1$)
- there is a constant static phase relation between the different DFB lasers ( $\Delta\varphi_k=(k-1)\Delta\varphi$ where $\Delta\varphi$ is a non-zero constant);
 the amplitude modulation of the beating wave becomes:

$$\alpha^2=\sin^2[(N+1)(\Omega t+\Delta\varphi)/2]/\sin^2(\Delta\varphi/2) \qquad (Eq.6)$$

and the additional phase of the beating wave is:

$$\beta=[(N+1)\Omega t+N\Delta\varphi]/2 \qquad (Eq.7)$$

This additional phase does not introduce any chirp.
In this case where $\Delta\varphi=0$,

$$\alpha^2=\cos^2[(N\Omega t)/2]/\cos^2(\Omega t/2) \qquad (Eq.8)$$

and

$$\beta=[(N-1)\Omega t]/2 \qquad (Eq.9)$$

Again in this case, no chirp is introduced.

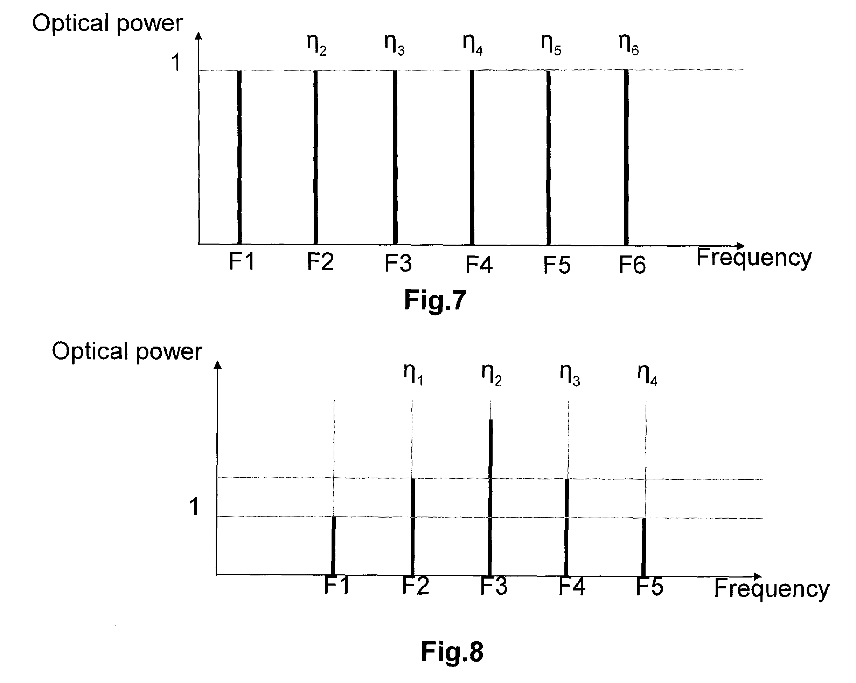

Fig.7 represents the optical spectrum after both instant phase shift and relative power settings. In this figure, in addition to the constant frequency spacing presented in Fig.6, the power amplitude of the different rays are all equal over the spectrum.
In the case of an odd number of beating modes (odd number of DFB lasers), an additional optional setting of the relative powers allowing to control the shape of the signal is possible.
In this case when the number of sections N is odd:
N=2m+1 with m an integer;
from Eq.5 it follows

$$\alpha=\eta_{m+}1+2\{\eta_1\cos(m\Omega t+\Delta\varphi_1)+\eta_2\cos[(m-1)\Omega t+\Delta\varphi_2]+...$$
$$+\eta_k\cos[(m+1-k)\Omega t+\Delta\varphi_k)+...+\eta_m\cos(\Omega t+\Delta\varphi_m)\} \qquad (Eq.10)$$

and

$$\beta=m\Omega t. \qquad (Eq.11)$$

However, several additional conditions are required to obtain a beating signal without chirp:

a) The relative powers have to be related 2 by 2 according to

$$\eta_k=\eta_{2m+2-k} \text{ for k=1..m.} \qquad (Eq.12)$$

Fig.8 shows the optical spectrum in the case of 5 laser diodes respecting Eq.12 relation.
Eq.12 implies that $\eta_1=\eta_5$ and $\eta_2=\eta_4$. Therefore 3 different settings remain to adjust the shape of the envelope of the beating wave ( $\eta_1$, $\eta_2$ and $\eta_3$).
b)The "static" phases have to be coupled 2 by 2 according to:

$$\Delta\varphi_k= - \Delta\varphi_{2m+2-k} \text{ for k=1..m.} \qquad (Eq.13)$$

In the general case for N=2m+1 waves, m independent parameters remain to adjust the shape of the beating wave after having eliminated (or substantially reduced) the chirp (application of the two previous conditions). Thus, in the case of an odd number of laser sections the shape of the signal can be adjusted while substantially reducing the chirp.
It has to be noticed that no assumption has been made on the way to integrate the different DFB laser sections which can be independent, separated or located on the same chip which is the preferred embodiment for economical reasons. Indeed, if the laser sections are separated, each DFB laser requires an optical coupling whereas in the case of integrated sections a single optical coupler is needed. In the case of independent DFB, an optical injection signal is to be used to lock all the static phases together, namely by using an external Fabry-Perot laser, which modes separation is equal to the mode separation $\Omega$ of the different DFB lasers.
Moreover, in the case of integration on a chip, two options are possible, either a common optical axis for all the laser sections (which is preferred, because four-wave mixing (FWM) can then occur in the whole structure, and thus no external Fabry-Perot injecting laser is needed) or different optical axis, an optical coupler and a single output waveguide to be coupled with an optical fiber.
In practice, the adjustment of the chirp starts with the setting of the relative powers of all the laser diodes at the same value and above their lasing threshold. Then, the instant phase shift is adjusted either automatically thanks to sufficient four-wave mixing (FWM), or with the heating electrodes to suppress this phase shift by equalizing the frequency difference between adjacent modes. In addition, the static phase shift between two adjacent modes has to be constant. Said static phase shift is adjusted by integration of the laser sources to set the optical differences between the different modes or by introduction of static phase adjustment sections on all except one optical paths. Thus, the total number of adjustment currents in the case of N laser sections becomes 3N-1, N power injection currents to polarize the laser diodes, N thermal adjustment currents and N-1 static phase adjustment currents.
In the same way, in the preferred embodiment where the number of laser diodes is odd (N=2m+1), the total number of adjustment currents is 3N-1 (if N optical coupling are needed) and the liberty to adjust m+1 power injection currents to control the shape of the envelope of the beating signal while canceling the chirp.
Thus, a multi-section DFB laser source allows to synthesize shape and chirp of the generated pulse by both controlling the power distribution among the different modes and the instant and static phase shifts between the different modes. Moreover, millimeter waves can be generated with reduced phase noise.

**Claims**

1.  A laser source comprising laser sections wherein at least three laser sections comprise each:

    - a distributed feedback laser (1) with a Bragg grating (5) having a predetermined grating period,
    - an active layer (3), and
    - an electrode adapted for being injected by an injection current (I),

    wherein the grating periods of said at least three laser sections are different from each other and wherein respective injection current values of said at least three laser sections are adjusted thereby adjusting the shape and chirp of a pulse generated by said at least three laser sections.

2.  A laser source according to claim 1 wherein,

    - said at least three laser sections are shifted in frequency by a predetermined value with respect to each other,
    - said at least three laser sections are shifted in phase by a predetermined value with respect to each other, thereby achieving a control of a simultaneous emission frequency of said at least three sections.

3.  A laser source according to claim 2 wherein the predetermined value of the frequency shift between two of said at least three laser sections is in a range from 20 to 100 GHz.

4.  A laser source in accordance with any of the previous claims wherein two laser sections of the at least three laser sections are injected with high intensity currents to produce a four-wave-mixing phenomenon whereas the other sections are injected with lower currents, the values of said lower currents being adjusted in order to control the shape of the generated pulses.

5.  A laser source in accordance with any of the previous claims wherein the injection current value of a laser section is above a lasing threshold value.

6.  A laser source in accordance with any of the previous claims wherein the active layer (3) of the distributed feedback laser (1) is a quantum dot structure or a quantum well structure or a bulk structure.

7.  A laser source in accordance with any of the previous claims wherein said at least three laser sections (1) comprise an adjustable heating device allowing to adjust the instant phase shift of the emitted light.

8.  A laser source in accordance with claim 7 wherein said adjustable heating device is a resistance.

9.  A laser source in accordance with any of the previous claims wherein a plurality of laser sections comprise each a static phase shift adjustment device and at least one laser section does not comprise a static phase shift adjustment device.

10. Method for adjusting the pulse shape and chirp of a laser source, said laser source comprising laser sections wherein at least three laser sections have respective grating periods being different from each other, respective active layers (3) and respective electrodes, the method comprising the steps of:

    - injecting an injection current by means of said electrode into a respective laser section,
    - adjusting the respective injection current values of said laser sections thereby adjusting the shape and chirp of a pulse generated by said at least three laser sections.

11. The method according to claim 10 wherein said at least three laser sections comprise a heating device, said method further comprising the step of:

    - adjusting the heating power produced by said heating device thereby adjusting the instant phase shift of said at least three laser sections in order to adjust the shape and chirp of a pulse generated by said at least three laser sections.

12. The method according to claim 10 or 11 wherein static phase shifts between laser sections are adjusted in accordance with a geometrical organization of the laser source on a chip.

**13.** The method according to claim 11 or 12 wherein static phase shifts are adjusted by static phase shift adjustment devices located on the optical paths.

**14.** The method according to claim 13 wherein said method comprises the following steps of:

- setting a value of said injection current above a lasing threshold,
- controlling instant phase shifts in order to make equal the frequency difference of the adjacent laser sections in the case when four-wave mixing is not occurring, and
- adjusting static phase shifts by means of static phase shift adjustment devices located on the optical paths is performed in case where the implementation of the different laser sections does not set said static phase shifts.

**15.** Method for generating millimeter wave using a laser source comprising laser sections wherein at least three laser sections comprise a distributed feedback laser (1) with a Bragg grating having respective grating periods wherein said respective grating periods are different from each other and comprise an active layer (3) and an electrode, wherein an injection current is injected into the electrode, and wherein two laser sections of said at least three laser sections are injected with high intensity currents to produce a four-wave-mixing phenomenon, the other sections being injected by lower intensity currents in order to control the shape of the generated pulses.

I1                    I2                    3      5      In

1

**Fig.1**

Optical power

|
|
|          |          |
|          |          |
|_____|_____|_____→ Frequency
          F1          F2

**Fig.2**

EP 2 113 973 A1

Optical power

F3    F1    F2    F4    Frequency

**Fig.3**

Optical power

F3    F1    F2    F4    Frequency

**Fig.4**

**Fig.5**

**Fig.6**

EP 2 113 973 A1

**Fig.7**

**Fig.8**

Europäisches
Patentamt

European
Patent Office

Office européen
des brevets

## EUROPEAN SEARCH REPORT

Application Number

EP 08 30 5135

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | AL-MUMIN ET AL: "Injection locked multi-section gain-coupled dual mode DFB laser for terahertz generation" OPTICS COMMUNICATIONS, NORTH-HOLLAND PUBLISHING CO. AMSTERDAM, NL, vol. 275, no. 1, 10 May 2007 (2007-05-10), pages 186-189, XP022070335 ISSN: 0030-4018 * the whole document * | 1-6,10, 12-15 | INV. H01S5/0625 H01S5/065 H01S5/12 H01S1/02 ADD. H01S5/042 H01S5/06 H01S5/40 |
| X | US 2008/037608 A1 (ZHOU YAN [US] ET AL) 14 February 2008 (2008-02-14) * paragraphs [0016] - [0018]; figures 3,4 * | 1,2,5-8, 10-13 | |
| X | LI W ET AL: "Multiwavelength Gain-Coupled DFB Laser Cascade: Design Modeling and Simulation" IEEE JOURNAL OF QUANTUM ELECTRONICS, IEEE SERVICE CENTER, PISCATAWAY, NJ, USA, vol. 36, no. 10, 1 October 2000 (2000-10-01), XP011052500 ISSN: 0018-9197 * page 1114, right-hand column - page 1116, left-hand column; figures 10,11,13 * | 1-3,5,6, 10,12,14 | TECHNICAL FIELDS SEARCHED (IPC) H01S |
| X | JP 08 111561 A (NIPPON TELEGRAPH & TELEPHONE) 30 April 1996 (1996-04-30) * abstract; figures 2,5 * | 1,2,5,6, 10 | |
| X | EP 0 836 255 A (NIPPON ELECTRIC CO [JP]) 15 April 1998 (1998-04-15) * column 9, line 50 - column 14, line 49; figures 1-3 * | 1,5,6,10 | |

-/--

The present search report has been drawn up for all claims

| Place of search | Date of completion of the search | Examiner |
|---|---|---|
| Munich | 4 December 2008 | Riechel, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 08 30 5135

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HYUK-KEE SUNG ET AL: "Optical generation of millimeter-waves using monolithic sideband injection locking of a two-section DFB laser" LEOS 2003. 16TH. ANNUAL MEETING OF THE IEEE LASERS & ELECTRO-OPTICS SOCIETY. TUCSON, AZ, OCT. 27 - 28, 2003; [ANNUAL MEETING OF THE IEEE LASERS AND ELECTRO-OPTICS SOCIETY], NEW YORK, NY : IEEE, US, vol. 2, 26 October 2003 (2003-10-26), pages 1005-1006, XP010674583 ISBN: 978-0-7803-7888-9 * the whole document * ----- | 1,10,15 | |
| A | DUAN G-H ET AL: "Injection-locking properties of self pulsation in semiconductor lasers" IEE PROCEEDINGS: OPTOELECTRONICS, INSTITUTION OF ELECTRICAL ENGINEERS, STEVENAGE, GB, vol. 144, no. 4, 19 August 1997 (1997-08-19), pages 228-234, XP006008857 ISSN: 1350-2433 * the whole document * ----- | 1,10 | TECHNICAL FIELDS SEARCHED (IPC) |

The present search report has been drawn up for all claims

| Place of search | Date of completion of the search | Examiner |
|---|---|---|
| Munich | 4 December 2008 | Riechel, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 30 5135

This annex lists the patent family members relating to the patent documents cited in the above-mentioned European search report.
The members are as contained in the European Patent Office EDP file on
The European Patent Office is in no way liable for these particulars which are merely given for the purpose of information.

04-12-2008

| Patent document cited in search report | | Publication date | Patent family member(s) | | Publication date |
|---|---|---|---|---|---|
| US 2008037608 | A1 | 14-02-2008 | NONE | | |
| JP 8111561 | A | 30-04-1996 | NONE | | |
| EP 0836255 | A | 15-04-1998 | DE 69709822 | D1 | 28-02-2002 |
| | | | DE 69709822 | T2 | 22-08-2002 |
| | | | JP 10117040 | A | 06-05-1998 |
| | | | US 5953359 | A | 14-09-1999 |

EPO FORM P0459

For more details about this annex : see Official Journal of the European Patent Office, No. 12/82